Europäisches Patentamt

European Patent Office

Office européen des brevets

(11) Publication number: **0 359 530**
A2

# EUROPEAN PATENT APPLICATION

(21) Application number: 89309263.5

(22) Date of filing: 12.09.89

(51) Int. Cl.⁵: **H 01 L 29/08**
H 01 L 29/78

(30) Priority: 15.09.88 US 244981

(43) Date of publication of application:
21.03.90 Bulletin 90/12

(84) Designated Contracting States:
AT BE CH DE ES FR GB GR IT LI LU NL SE

(71) Applicant: ADVANCED MICRO DEVICES, INC.
901 Thompson Place P.O. Box 3453
Sunnyvale, CA 94088 (US)

(72) Inventor: Haskell, Jacob D.
1301 Forest Avenue
Palo Alto, California (US)

(74) Representative: Sanders, Peter Colin Christopher et al
BROOKES & MARTIN High Holborn House 52/54 High Holborn
London WC1V 6SE (GB)

(54) Capacitive reduction of junctions in a semiconductor device.

(57) The invention is for a metal oxide semiconductor device whose operative speed is increased as a result of the reduction in "bottom wall" capacitance of a junction, which capacitance is achieved without influencing the short channel, punch through characteristics.

EP 0 359 530 A2

**Description**

## CAPACITIVE REDUCTION OF JUNCTIONS IN A SEMICONDUCTOR DEVICE

BACKGROUND OF THE INVENTION

The present invention relates to a metal oxide semiconductor device having higher operative speed as a result of reduction in the "bottom wall" capacitance of a junction disposed about a gate.

A P-N type junction has an inherent capacitance due to the doping gradient and resulting from its physical structure under reverse biasing.

It has always been contemplated, that if the depletion width about the junction could be extended away from the P-N junction, capacitance could be reduced. The reduction of capacitance would provide for a higher operative speed when the junction forms a driven capacitive load.

There are several approaches for accomplishing the aforementioned objective, one of which is to reduce the doping of the "N" area. While this is a viable solution to the problem, it has the drawback of requiring the doping to be accomplished selectively. If not done in this fashion, the source/drain junctions depletion width will cause a short channel to result in the transistor, resulting in a punch through failure.

The above problem is shown in United States Patent No. 4,001,048 to Meiling et al. In this patent, short channel transistors cannot be fabricated, because of the lack of selective reduction of junction capacitance.

One method of selective doping utilizes a "graded" junction (i.e., one that does not have an abrupt or distinct demarcation). Such a graded junction provides the advantage of increasing the depletion width to the graded depth.

This type of selective doping can be accomplished by two diffusions. Unfortunately, this approach does not solve the problem of punch through. In addition, the above technique is limited, in that capacitive reduction is proportional only to the increase in depletion width.

Graded-type junctions are illustrated in United States Patent Nos. 4,442,591 and 4,038,107 to Hacken and Marr et al, respectively. Neither of these patents reduce the capacitance in a completely satisfactory manner.

Another interesting approach is that depicted in United States Patent No. 4,342,149 to Jacobs et al. In this patent, the "bottom wall" capacitance is increased by the formation of pockets in the structure, which provides a quasi-graded junction of higher and opposite doping.

The present invention seeks a different approach to the above objective; one which will not require selective doping techniques, and will resolve the problems of the prior devices.

Accordingly, there is described herein a method of fabricating a metal oxide semiconductor device having a higher operative speed when the junction forms a driven capacitive load. The device has a junction of same polarity disposed on either side of a gate. The junctions are highly doped. Buried beneath the junction is a region of low doping.

When a potential is applied, the depletion region extends outwardly from the junction and coalesces with the low doped region causing a reduction in the "bottom wall" capacitance without comprising the punch through, short channel character of the device. The method is applicable to both PMOS and NMOS devices.

The described method increases the operative speed of a semiconductor device, and enables fabrication of an improved metal oxide semiconductor device having reduced "bottom wall" capacitance without resorting to selective doping techniques, and without sacrificing the short channel, punch through character of the transistor.

In the accompanying drawings, by way of example only:-

FIGURE 1 is an enlarged schematic, sectional view of a typical semiconductor device to which the present invention is directed;

FIGURE 2 is an enlarged schematic, sectional view of a prior art semiconductor device experiencing the problem of punch through;

FIGURE 3a is an enlarged sectional view of the invention featuring a heavily doped junction with a low doped region buried beneath it;

FIGURE 3b is the sectional view of FIGURE 3a illustrating the effect of the extension under bias of the depletion region from the junction and its coalescence with the low doped region disposed below;

FIGURE 3c is an enlarged sectional view of an alternate embodiment of the inventive junction shown in FIGURE 3a; and

FIGURE 4 is a graph of the concentration verses the depth in the silicon substrate for the N+ area and implant straggle, and the depth beyond which the second implant is made.

Generally speaking, the invention pertains to a new metal oxide semiconductor structure, wherein operational speed is enhanced by reduction of "bottom wall" capacitance. For the sake of clarity, like elements will have the same designation throughout the figures.

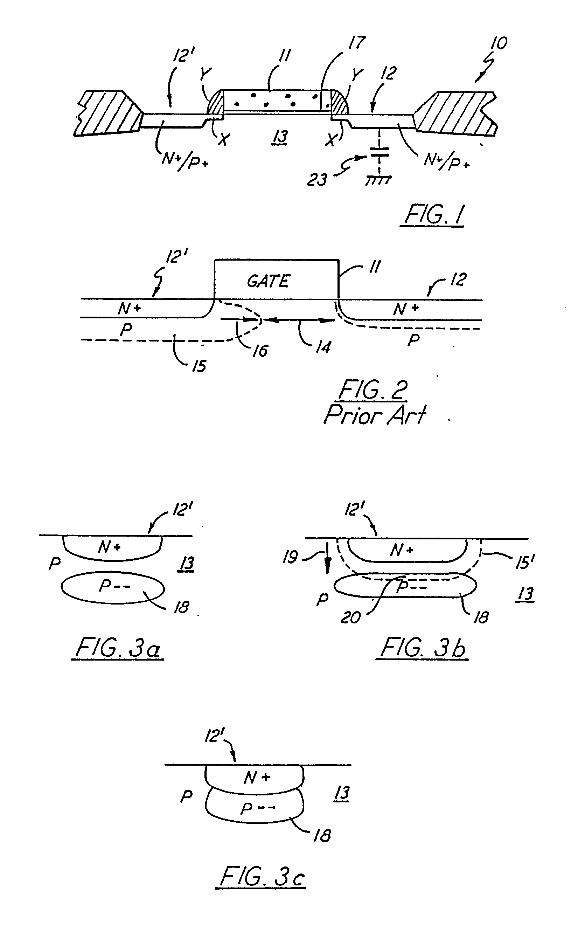

Referring to FIGURE 1, a sectional view of a typical semiconductor device (arrow 10) is shown. The device 10 comprises a gate 11 having junctions 12 and 12', respectively on either side thereof. It is desired to reduce the bottom wall capacitance 13, as schematically shown.

The prior art has attempted to achieve the above objective by selectively doping or grading junctions 12, but while "bottom wall" capacitance is reduced, the short channel characteristic (arrow 14) is affected, as illustrated in FIGURE 2. While the depletion region 15 extends vertically from junction 12 under reverse bias, it also expands laterally (arrow 16) to narrow or shorten channel 14, causing a greater tendency for punch through.

Referring to FIGURE 3a, a heavily doped junction 12′ of the invention is shown. Normally, the heavy doping increases the capacitance of junction 12′ with respect to substrate 13. Directly beneath the junction 12′ is buried a low doped region 18.

The effect of placing region 18 below the junction 12′ is depicted in FIGURE 3b. Under a reverse bias, the depletion region 15′ extends vertically (arrow 19), where it is caused to coalesce with the low doped region 18, as illustrated as overlap area 20.

Placement of the low doped region 18 beneath the heavily doped junction 12′, allows the depletion region 15′ to grow only vertically and <u>not laterally</u>, as depicted in FIGURE 2.

Thus, the "bottom wall" capacitance is reduced without effecting a shortened channel 14 as depicted in the prior art schematic view of FIGURE 2.

The inventive structure of FIGURES 3a and 3b is fabricated in ways traditional in the field. A fabrication technique for a field implant is described in United States Patent No. 4,306,916, or alternately is illustrated in the article, entitled: "Silicon Gate N. Well CMOS Process by Full Ion Implantation Technology," by T. Ohzone et al, published in IEEE Transactions on Electron Devices, Volume Ed. 27, No. 9, September 1980, at page 1789. Junctions 12 and 12′ can feature either a N-type material followed by a P-type mask, or vice versa.

Referring to FIGURE 3c, an alternate embodiment is depicted of the invention shown in FIGURE 3a. In this embodiment, the buried low doped region 18 can be disposed contiguously or directly beneath the junction 12′ without any space therebetween.

To obtain a good short channel device, the doping under the gate needs to be high enough (consistent with the gate oxide thickness 17, shown in FIGURE 1) to obtain a desired threshold voltage. While this will generally raise the capacitance of junction 12′ and the underlying substrate 13, the inclusion of the low doped region 18 reduces the "bottom wall" capacitance.

The general sequence of fabricating the invention is described below, and is useful in constructing both PMOS and NMOS devices.

A typical semiconductor device consistent with the invention will feature a gate 11 of N+ or P+ polysilicon of approximately 0.25 to 0.5 microns thick. The residual gate oxide 17 is approximately 175 to 500 Angstroms thick, and the substrate 13, which is P or N as the case may be, is approximately between $10^{15}$ to $10^{16}$ cm$^{-3}$.

Next a N+ (photoresist) mask, which can also be P+ if the P-channel device is made first, is defined on a semiconductor substrate.

Next, the N+ region is heavily doped with arsenic or phosphorus, by ion implantation. This layer of resist is then removed.

Then a layer of photoresist is deposited.

A P+ mask is then defined followed by doping with BF$_2$ + B$_{11}$ or BF$_2$, using ion implantation.

These implants are activated by a rapid thermal annealing process or by a very short furnace cycle.

The second implant step in the above sequence is chosen such that the energy and dose reduce the background doping beyond the distribution of the first implant step.

Example:
Assuming an arsenic implant for the source and drain areas and a residual oxide of 125 Å after polysilicon gate definition, proceed as follows:

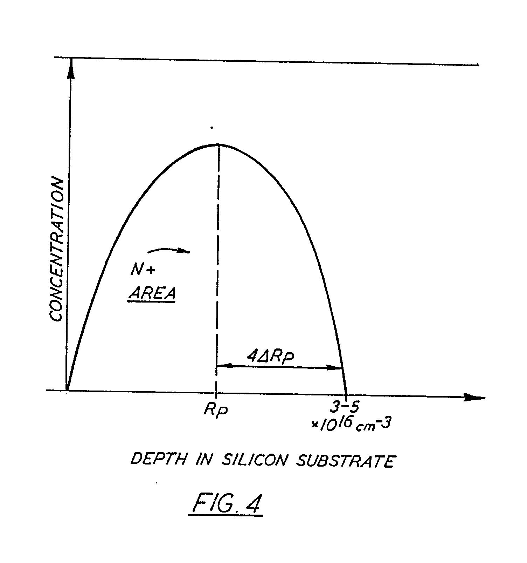

1) Using 40 Kev arsenic, the range in oxide is Rp = 217 Å and ΔRp (the implant straggle) is 72 Å. Referring to FIGURE 4, the distribution then occupies a total range of Rp + 4ΔRp
= 217 + 4(72)
= 500 Å.

2) It is desired to position the peak of the second implant beyond this. Using arsenic again, select Rp > 500 Å or 100 Kev for the bottom wall implant.

In scaled CMOS, the well (P well for this example) background doping is typically 3-5 x $10^{16}$ cm$^{-3}$.

Then the ion implant dose is selected such that the peak concentration (Np) is, for a Gaussian distribution, given by

$$Np = \frac{0.4\varphi}{\Delta Rp}$$

where Np is already defined, and φ is the ion implant dose in ions per cm$^2$.

Since the background is ≃ 3-5 x $10^{16}$ cm$^{-3}$, it will be assumed that a dopant Np (not wishing to convert the background doping but to reduce it) is approximately $10^{16}$ cm$^{-3}$.

Then,

$$Np = 10^{16} = \frac{0.4\varphi}{\Delta Rp}$$

$$\text{or } \varphi = \frac{10^{16} \times \Delta Rp}{0.4}$$

at 100 Kev, ΔRp for arsenic = 0.21µ = .021 x 10$^4$ cm.

$$= \frac{10^{16} \times .021 \times 10^{-4}}{0.4}$$

= 6 x $10^{10}$ ions/cm$^2$

The two implants are now activated using a rapid thermal anneal of 900°C for 15 seconds.

In the formation of a typical LDD (low doped drain) device (FIGURE 1) with the above example, the oxide "spacers" Y (FIGURE 1) over the lightly doped drain would have a typical thickness of approximately 3000 to 5000 Angstroms. In addition, the light dose implants to form the N areas X (FIGURE 1) use phosphorous or arsenic at approximately $10^{13}$ cm$^{-2}$ at 50 to 100 Kev; and for P- in a PMOS device, BF$_2$ of approximately $10^{13}$ cm$^{-2}$ at 60 Kev.

The maskless oxide etch used to form these oxide spacers Y uses an etch chemistry with selectivity to the silicon and polysilicon surfaces adequate to provide a ratio equal to or greater than 10:1.

The heavy ion implant which defines the N+ or P+ junctions uses a photoresist mask and typically arsenic at $10^{15}$ to $10^{16}$ cm$^{-2}$ at 40 to 80 Kev for N+ and boron at $10^{15}$ to $10^{16}$ cm$^{-2}$ at 10 to 15 Kev for P+.

A background doping of 3-5 x $10^{16}$ cm$^{-3}$ is assumed for the substrate.

Since other modifications and changes varied to fit particular operating requirements and environments will be apparent to those skilled in the art, the invention is not considered limited to the example chosen for purposes of disclosure, and covers all changes and modifications within the scope of the claims.

## Claims

1. A metal oxide semiconductor device having a relatively heavily doped junction disposed on either side of a gate, each said junction being of the same polarity, and a relatively low doped region with respect to said heavily doped junction disposed beneath at least one of said relatively heavily doped junctions, whereby when a potential is applied to said device, a depletion region disposed about said heavily doped junction extends outwardly from said heavily doped junction and coalesces with said relatively low doped region causing "bottom wall" capacitance to be reduced without compromising the punch through short channel character of said device.

2. The metal oxide semiconductor device of claim 1, wherein each junction is a N+ junction.

3. The metal oxide semiconductor device of claim 1, wherein each junction is a P+ junction.

4. The metal oxide semiconductor device of claim 1, wherein said device is a PMOS device.

5. The metal oxide semiconductor device of claim 1, wherein said device is a NMOS device.

6. The metal oxide semiconductor device of claim 1, wherein a relatively low doped region is disposed beneath both of said heavily doped junctions.

7. The metal oxide semiconductor device of claim 2, wherein said N+ junction is doped with arsenic.

8. The metal oxide semiconductor device of claim 7, wherein said low doped region is doped with BF$_2$.

9. The metal oxide semiconductor device of claim 2, wherein said low doped region is doped with BF$_2$.

10. In a metal oxide semiconductor device having a junction disposed on either side of a gate, said junctions having the same polarity and each being relatively heavily doped, the method of increasing the operative speed of said device by reducing "bottom wall" capacitance without compromising the punch through short channel character of said device, said method comprising the step of disposing beneath at least one of said junctions a relatively low doped region with respect to said heavily doped junction, whereby when a potential is applied to said device, a depletion region disposed about said heavily doped junction will be caused to extend outwardly from said junction and coalesce with said low doped region, thus reducing said "bottom wall" capacitance.

11. The method of claim 10, wherein said low doped region is disposed beneath both junctions.

12. The method of claim 10, wherein said device is a PMOS device.

13. The method of claim 10, wherein said device is a NMOS device.

14. The method of claim 10, wherein each junction is a P+ junction.

15. The method of claim 10, wherein each junction is a N+ junction.

16. The method of claim 15, wherein said N+ junction is doped with arsenic.

17. The method of claim 16, wherein said low doped region is doped with BF$_2$.

18. The method of claim 15, wherein said low doped region is doped with BF$_2$.

19. In a metal oxide semiconductor device having a relatively heavily doped junction disposed on either side of a gate, the improvement comprising burying a relatively low doped region beneath at least one of said junctions in order to increase the operative speed of said device by reducing "bottom wall" capacitance without compromising the punch through, short channel character of said device.

20. The semiconductor device of claim 19, wherein said low doped region is buried beneath both junctions.

*FIG. 1*

*FIG. 2*
*Prior Art*

*FIG. 3a*

*FIG. 3b*

*FIG. 3c*

DEPTH IN SILICON SUBSTRATE

FIG. 4